# EUROPEAN PATENT APPLICATION

(11) **EP 1 223 471 A1**
(43) Date of publication of application: **17.07.2002**
(21) Application number: 01129867.6
(22) Date of filing: 14.12.2001
(51) Int. Cl.: G03F 9/00, G03F 7/20

(54) **Substrate positioning apparatus and exposure apparatus**

(30) Priority: 27.12.2000 JP 2000396594; 21.06.2001 JP 2001187586; 02.11.2001 JP 2001337746
(71) Applicant: SANEI GIKEN CO., LTD., Amagasaki-shi, Hyogo-ken (JP)
(72) Inventor: Miyake, Eiichi, 1-chome, Amagasaki-shi, Hyogo (JP)
(74) Representative: Prüfer, Lutz H., Dipl.-Phys.

(57) **Abstract**

A substrate positioning apparatus and an exposure apparatus includes a rotary circular eccentric cam mechanism (100) as an X direction moving mechanism, in contact with one end (A) of a support body (30) holding a substrate (2), and rotary circular eccentric cam mechanisms (110, 120) as first and second Y direction moving mechanisms, offset in the X direction with each other, to be in contact with another side (B) of the support body (30). As a result, a substrate positioning apparatus and an exposure apparatus having simple and inexpensive structure that provides satisfactory accuracy and reliability can be provided.

## Description

### BACKGROUND OF THE INVENTION

### Field of the Invention

The present invention relates to a substrate positioning apparatus and an exposure apparatus. More specifically, the present invention relates to a substrate positioning apparatus and an exposure apparatus that have a simple and inexpensive structure performing positioning of a printed circuit board, a substrate for a flat display, a semiconductor substrate, a glass substrate or the like (hereinafter simply referred to as a substrate) or a relative positioning between a photomask and a substrate, with sufficient accuracy and reliability.

### Description of the Background Art

Conventionally, a substrate positioning apparatus is provided with a moving apparatus for moving a substrate supporting body supporting a substrate in X, Y and θ, directions. The moving apparatus is arranged such that moving apparatuses for X, Y and θ, respectively, are stacked, or two moving apparatuses for Y direction are positioned on one side of a rectangle of the substrate supporting body with a space between each other, and an X direction moving apparatus is positioned on an adjacent one side, and the X direction moving apparatus and two Y direction moving apparatuses are differentially moved, so that the substrate is moved in the X, Y and θ directions.

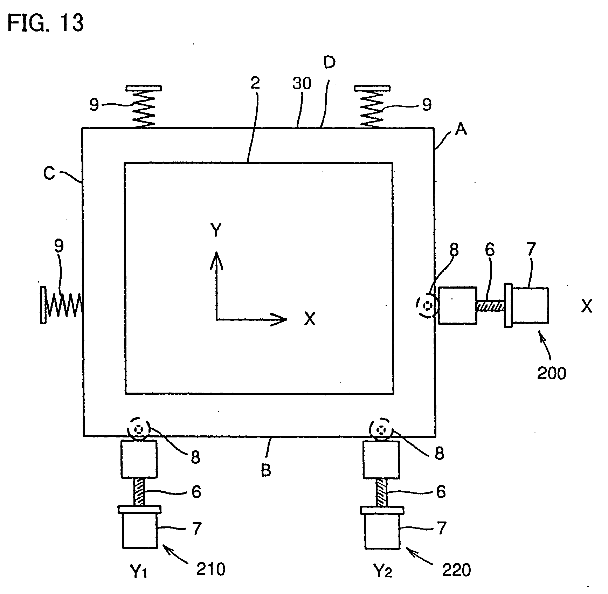

Referring to Fig. 13, a structure of a moving apparatus employing a conventional positioning method using a motor and a ball screw, used for the substrate positioning apparatus will be described. In the moving apparatus, a method is used in which the substrate is moved in the X, Y and θ directions, so that the substrate is positioned.

A substrate 2 is held by a support body 30. On two sides (A, B) of support body 30, rotating bodies 8 are provided. In contact with the rotating bodies 8, an X direction moving apparatus 200, a first Y direction moving apparatus 210 and a second Y direction moving apparatus 220, each including a ball screw 6 and motor 7, are provided for moving support body 30.

On two sides (C, D) opposing to the aforementioned two sides (A, B) of support body 30, springs 9 are provided, one on the side C and two on the side D, so that support body 30 is pressed against X direction moving apparatus 200, first Y direction moving apparatus 210 and the second Y direction moving apparatus 220.

In an exposure apparatus, it is very important to align a photomask and a substrate with high accuracy, before transferring the pattern drawn on the photomask to the substrate by irradiating the substrate with light through the photomask. In the alignment, conventionally, a method has been adapted in which the photomask and the substrate are moved in X, Y and θ directions relative to each other, with the photomask and the substrates overlapped in contact with each other or at a close distance with each other. Here, θ direction represents a direction of rotation in the same plane as the X and Y directions.

The method of moving in the X, Y and θ directions is realized, similar to the substrate positioning apparatus described above, by stacking apparatuses for moving in the X, Y and θ directions, respectively, or by providing two Y direction moving apparatuses spaced apart from each other along one side of a rectangular holding means (means for holding the photomask or the substrate) and by providing one X direction moving apparatus along another, neighboring side. In the latter method, the position in the X direction is adjusted by the X direction moving apparatus, the position in the Y direction is adjusted by the Y direction moving apparatus, and the position in the θ direction is adjusted by differentially moving the two Y direction moving apparatuses.

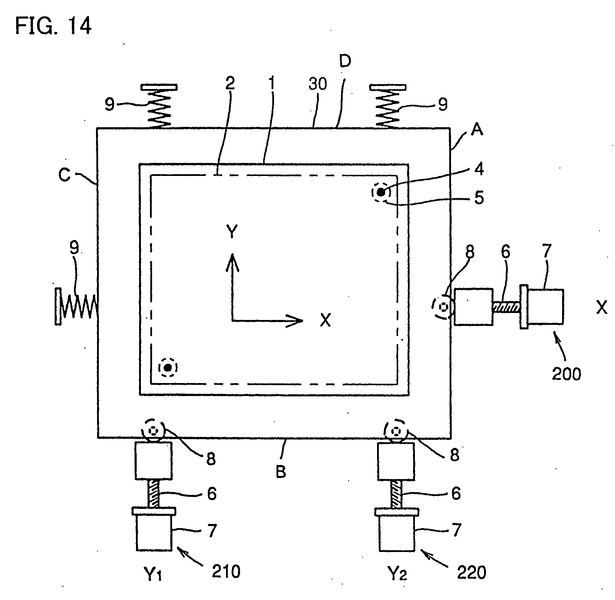

Referring to Fig. 14, the structure of the moving apparatus employing the conventional positioning method using motors and ball screws will be described. In the moving apparatus, alignment is attained by moving the photomask in the X, Y and θ directions with respect to a fixed substrate.

A photomask 1 is held by a support body 30. On two sides (A, B) of support body 30, rotating bodies 8 are provided. Further, an X direction moving apparatus 200, a first Y direction moving apparatus 210 and a second Y direction moving apparatus 220, each including a ball screw 6, a motor 7 and the like, in contact with the rotating body 8 for moving the support body 30 are provided.

Further, on two sides (C, D) opposing to the two sides (A, B) of support body 30, springs 9 are provided, one on the side C and two on the side D, so that support body 30 is pressed to X direction moving apparatus 200 and the first and second Y direction moving apparatuses 210 and 220.

On photomask 1 and substrate 2, there are photomask alignment mark 4 and substrate alignment mark 5, provided at corresponding positions. With the photomask 1 and substrate 2 overlapped, a CCD camera (not shown) reads the alignment marks 4 and 5 of the photomask 1 and substrate 2, and based on the data of the amount of positional deviation, the X direction moving apparatus 200 and the first and second Y direction moving apparatuses 210 and 220 are driven so that photomask 1 is moved in the X, Y and θ directions and photomask 1 and substrate 2 are aligned.

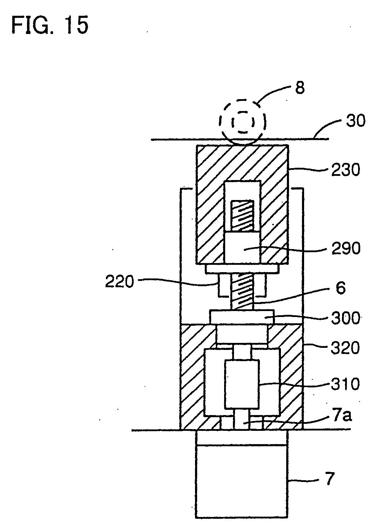

The structure of the X direction moving apparatus 200 and the first and second Y direction moving apparatuses 210 and 220 that are used in the substrate positioning apparatus and the exposure apparatus above will be described in detail, with reference to Fig. 15. Each moving apparatus includes a motor 7, a motor shaft 7a, a ball screw 6, a coupling 310 coupling motor shaft 7a with ball screw 6, a thrust bearing 300 receiving the thrust of ball screw 6, a female screw 290 to be engaged with ball screw 6, an end fitting 230, a linear bearing 220 for linearly guiding the end fitting 230, and a frame 320 supporting these members.

Provision on the two Y direction moving apparatuses and one X direction moving apparatus on another adjacent side in the above described substrate positioning apparatus and the exposure apparatus is advantageous in that the structure is relatively simple and can be made compact. The substrate positioning apparatus and the exposure apparatus as a whole, however, become expensive, as expensive ball screws 6 and thrust bearings 300 receiving the thrust of ball screws 6 are required in addition to linear bearings 220 for linear movement, the number of components is large, and assembly with the axial centers of various parts aligned is difficult.

### SUMMARY OF THE INVENTION

The present invention was made to solve the above described problems, and a first object is to provide a substrate positioning apparatus having a simple and inexpensive structure that performs substrate positioning with satisfactory accuracy and reliability.

A second object is to provide a substrate positioning apparatus having a simple and inexpensive structure performing relative positioning between a photomask and a substrate with satisfactory accuracy and reliability.

The present invention provides a substrate positioning apparatus having a base plate, holding means provided on the base plate and holding a substrate movable in X, Y and θ directions including the plane of the substrate, for detecting positions of a plurality of sides of the substrate or positions of positioning marks by a position detection sensor, calculating an offset from a predetermined substrate position, moving the holding means in the X, Y and θ directions based on the result of calculation so that the substrate is positioned to eliminate the offset, including an X direction moving mechanism for moving the holding means in the X direction, a first Y direction moving mechanism for moving the holding means in the Y direction, and a second Y direction moving mechanism positioned offset in the X direction from the first Y direction moving mechanism, for moving the holding means in the Y direction, wherein the X direction moving mechanism and the first and second Y direction moving mechanisms are implemented by rotating cam mechanisms that are in contact with the holding means.

By this structure, the X direction moving mechanism and the first and second Y direction moving mechanisms are implemented by using rotating cam mechanisms, and therefore, the moving mechanisms can be simplified, and the cost necessary for each moving apparatus can be reduced. By accurately controlling the rotating angle of the rotating cam, the amount of movement of the holding apparatus can be controlled accurately, and hence accuracy of the moving distance and the reliability can be improved.

In a preferred embodiment of the invention, the rotating cam mechanism includes an eccentric rotary member consisting of a disk eccentrically attached on a rotary shaft, or a cylindrical, circular eccentric cam, and a rolling bearing fit in an outer periphery of the eccentric rotary member, with the outer periphery of the rolling bearing being in contact with the holding means.

More preferably, the rotary shaft includes reading means for reading the angle of rotation of the eccentric rotary member.

In a more preferred embodiment of the invention, based on the amount of positional deviation of the substrate read by the position detection sensor, necessary angle of rotation of each of the circular eccentric cam to eliminate the positional deviation of the substrate is calculated by a processor, and each circular eccentric cam is rotated in accordance with the data.

In a more preferred embodiment, a fixing mark positioned outer than the sides of the substrate is provided on the base plate, distance between the plurality of sides of the substrate or the positioning mark and the fixing mark is read by the position detection sensor, and the substrate is positioned such that the distance between the plurality of sides of the substrate or the positioning mark and the fixing mark attains to a predetermined value, based on the read data.

In a more preferred embodiment, as each eccentric rotary member, a structure is adapted in which the disk-shaped or the cylindrical circular eccentric cam is directly attached on an output shaft of a motor of which angle of rotation is controllable.

The present invention provides an exposure apparatus in which a photomask and a substrate are overlapped close to each other or in contact with each other, for transferring a pattern drawn on the photomasks to the substrate by irradiating the substrate with light through the photomask, and the apparatus has the following structure.

More specifically, the exposure apparatus includes an alignment apparatus for aligning the photomask and the substrate, wherein the photomask and the substrate are provided with a plurality of alignment marks at corresponding positions, respectively, the alignment marks on the photomask and the substrate are read by a CCD camera with the photomask and the substrate being overlapped, and the photomask and the substrate are moved in X, Y and θ directions relative to each other based on the data read by the CCD camera, so that the photomask and the substrate are aligned.

The alignment apparatus has a holding apparatus holding one of the photomask and the substrate that moves, and movable in the direction of the plane of the photomask or the substrate; an X direction moving mechanism for moving the holding apparatus in the X direction; a first Y direction moving mechanism for moving the holding apparatus in the Y direction; and a second Y direction moving mechanism for moving the holding apparatus in the Y direction, positioned offset in the X direction from the first Y direction moving mechanism. Further, the X direction moving mechanism and the first and second Y direction moving mechanisms are implemented by rotating cam mechanisms that are in contact with the holding apparatus.

By this structure, the X direction moving mechanism and the first and second Y direction moving mechanisms are implemented by using rotating cam mechanisms, and therefore the moving mechanisms can be simplified and the cost necessary for each moving apparatus can be reduced. By accurately controlling the rotating angle of the rotating cam, the amount of movement of the holding apparatus can be controlled accurately, and hence accuracy of the moving distance and the reliability can be improved.

In a preferred embodiment of the present invention, the rotating cam mechanism includes a disk eccentrically attached on a rotary shaft, or an eccentrical rotary member consisting of a circular eccentric cam, and a rolling baring fit in an outer periphery of the eccentric rotary member, with the outer periphery of the rolling bearing being in contact with the holding apparatus.

More preferably, the rotary shaft further includes a reading apparatus for reading the angle of rotation of the eccentric rotary member.

In a more preferred embodiment, there is further provided an image processing apparatus for recognizing the amount of positional deviation between the photomask and the substrate read by the CCD camera, calculating means calculating the amount of positional deviation between the photomask and the substrate based on the information from the image processing apparatus, and an output apparatus applying a necessary angle of rotation of each eccentric rotary member, to the X direction moving mechanism and the first and second Y direction moving mechanisms so as to eliminate the positional deviation between the photomask and the substrate.

In a more preferred embodiment, as each eccentric rotary member, a structure is adapted in which the disk or the cylindrical, circular eccentric cam is directly attached on an output shaft of a motor of which angle of rotation is controllable.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 shows a principle of the method of positioning using a rotary circular eccentric cam of the substrate positioning apparatus in accordance with a first embodiment.

Fig. 2A is a schematic illustration representing the relation between "angle of rotation θ of circular eccentric cam 11" and "amount of movement S of support body 3" and Fig. 2B is a graph representing the relation between "angle of rotation θ of circular eccentric cam 11" and "amount of movement S of support body 3."

Fig. 3 is a plan view (viewed from the line III-III of Fig. 4) showing the structure of the substrate positioning apparatus in accordance with the first embodiment.

Fig. 4 is a cross sectional view taken along the line IV-IV of Fig. 3.

Fig. 5 is a perspective view representing positional relation between each of upper base plate 24A, fixing marks 6, 7 and 8 and a substrate base plate 30C of the substrate positioning apparatus in accordance with the first embodiment.

Fig. 6 is a perspective view representing positional relation between each of upper base plate 24A, a lower base plate 24B, a first support body 30A, a second support body 30B and substrate base plate 30C of the substrate positioning apparatus in accordance with the first embodiment, except for fixing marks 6, 7 and 8.

Fig. 7 shows detailed structure of the supporting portion of support body 30 of the substrate positioning apparatus in accordance with the first embodiment.

Fig. 8 shows positioning of substrate 2 and support body 30 by the substrate positioning apparatus in accordance with the first embodiment.

Fig. 9 shows a principle of the alignment method using the rotary circular eccentric cam of the exposure apparatus in accordance with a second embodiment.

Fig. 10 is a block diagram of a processor in the exposure apparatus in accordance with the second embodiment.

Fig. 11 is a plan view (viewed from the direction of the arrow XI-XI of Fig. 12) showing the structure of the exposure apparatus in accordance with the second embodiment.

Fig. 12 is a cross sectional view taken along the line XII-XII of Fig.11.

Fig. 13 shows a principle of the positioning method of conventional substrate positioning apparatus.

Fig. 14 shows a principle of the method of alignment of the conventional exposure apparatus.

Fig. 15 shows a structure of the conventional moving apparatus used in the substrate positioning apparatus and the exposure apparatus.

### DESCRIPTION OF THE PREFERRED EMBODIMENTS

Embodiments of the substrate positioning apparatus and the exposure apparatus to which the present invention is applied will be described with reference to the figures.

### (First Embodiment)

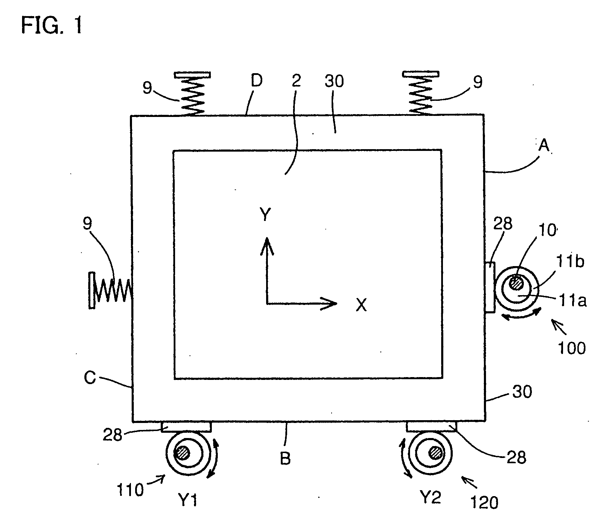

The structure of the substrate positioning apparatus in accordance with the present embodiment will be described with reference to Fig. 1. Fig. 1 shows the principle of positioning using the rotary circular eccentric cam of the substrate positioning apparatus in accordance with the present embodiment. Portion the same as or corresponding to those of the conventional substrate positioning apparatus described with reference to Fig. 13 will be denoted by the same reference characters, and detailed description thereof will not be repeated.

### (Schematic Structure of the Substrate Positioning Apparatus)

Referring to Fig. 1, the substrate positioning apparatus in accordance with the present embodiment is characterized by rotary circular eccentric cam mechanisms 100, 110, and 120.

More specifically, a rotary circular eccentric cam mechanism 100 is provided as the X direction moving mechanism to be in contact with one side (A) of support body 30 holding substrate 2, and a rotary circular eccentric cam mechanism 110 as the first Y direction moving mechanism and a rotary circular eccentric cam mechanism 120 as the second Y direction moving mechanism are provided at positions offset in the X direction, to be in contact with another side (B) of support body 30. By this structure, it becomes possible to move the substrate in the X, Y and θ directions. Here, θ direction refers to a direction of rotation in the same plane as the X and Y directions.

The rotary circular eccentric cam mechanism includes a rolling bearing 11b in contact with a support body fitting 28 provided on a side of support body 30, a circular eccentric cam 11a to which outer peripheral surface the rolling bearing 11b is fitted, and a rotary shaft 10 transmitting rotary driving force to the circular eccentric cam 11a.

### (Relation Between the Angle of Rotation θ and the Amount of Movement S)

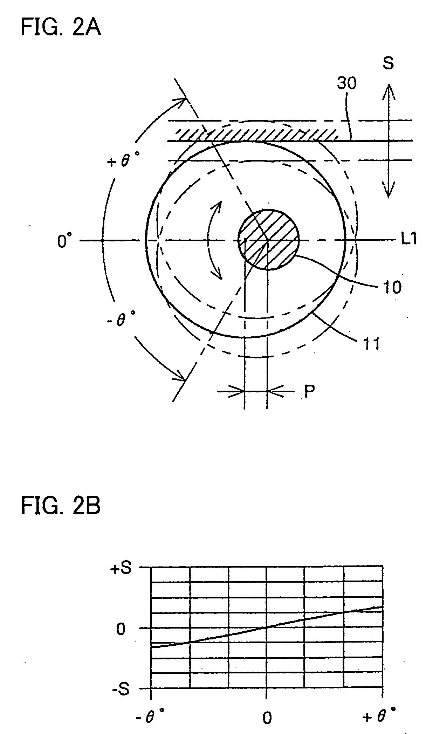

Referring to Figs. 2A and 2B, the relation between "the angle of rotation θ of the circular eccentric cam 11" and "the amount of movement S of support body 30" will be described. Referring to Fig. 2A, assume that a position, where a line (L1) connecting the center of the rotary shaft 10 and the center of the circular eccentric cam 11 is parallel to one side of support body 30 with which circular eccentric cam 11 is in contact, is considered as the origin (0 point) of the angle of rotation θ. Assuming that one side of support body 30 moves parallel to the line (L1), the relation between the "angle of rotation θ of circular eccentric cam 11" and "the amount of movement S of support body 30" when the circular eccentric cam 11 is rotated in ± directions is as shown by the graph of Fig. 2B. The curve of the graph can be represented by the equation S = sin θ.

### (Specific Structure of the Substrate Positioning Apparatus)

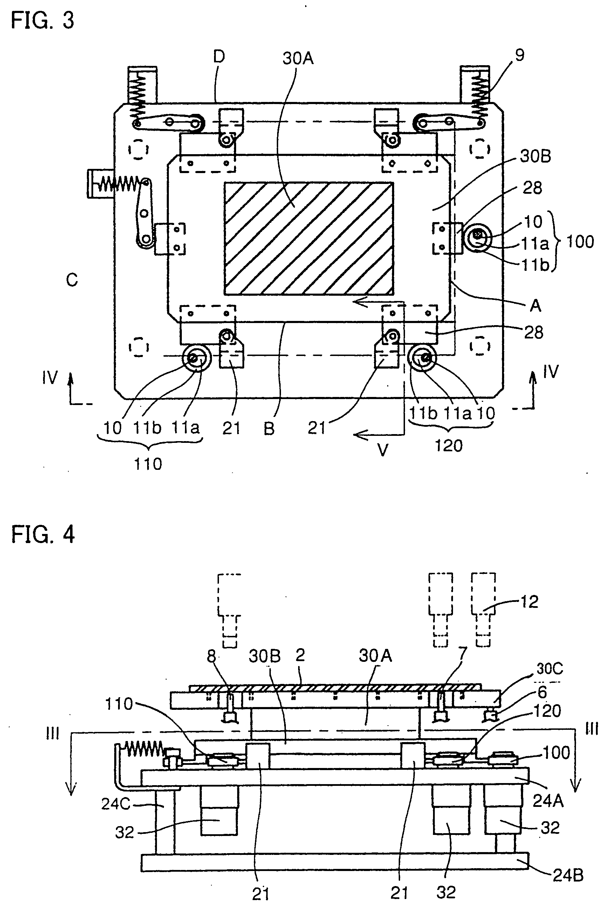

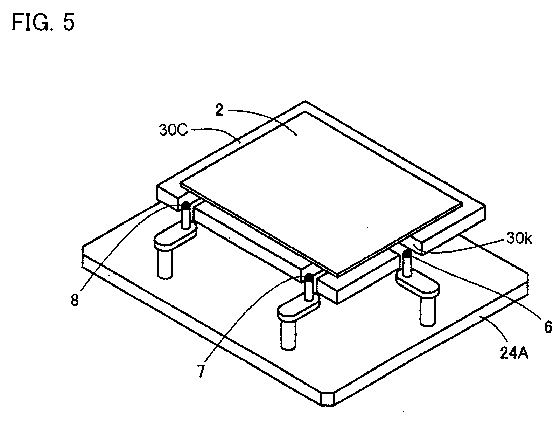

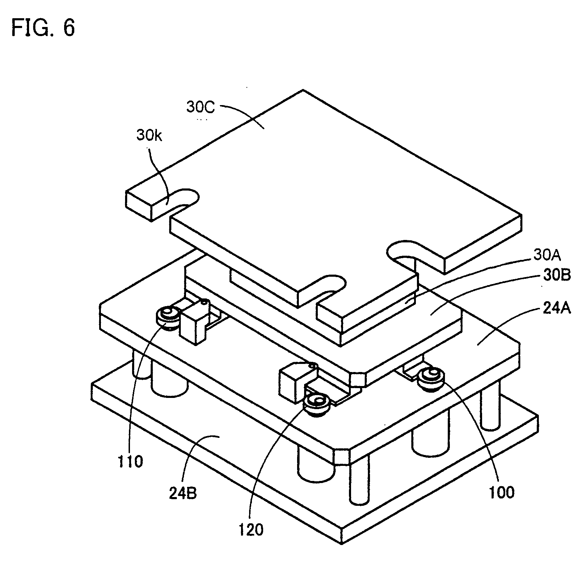

Referring to Figs. 3 and 6, more specific structure of the substrate positioning apparatus using the rotary circular eccentric cam mechanism in accordance with the present embodiment will be described. Fig. 3 is a plan view (viewed from the line III-III of Fig. 4) showing the structure of the substrate positioning apparatus of the present embodiment, and Fig. 4 is a cross sectional view taken along the line IV-IV of Fig. 3. Fig. 5 is a perspective view representing positional relation between each of upper base plate 24A, fixing marks 6, 7 and 8 and a substrate base plate 30C, and Fig. 6 is a perspective view representing positional relation between each of upper base plate 24A, a lower base plate 24B, a first support body 30A, a second support body 30B and substrate base plate 30C, except for fixing marks 6, 7 and 8.

Substrate 2 is supported by vacuum suction on a substrate base plate 30C. Substrate base plate 30C is mounted to fix on a second support body 30B with a first support body 30A interposed. On one side (A) of second support body 30B, a support body fitting 28 is provided and rotary circular eccentric cam mechanism 100 as the X direction moving mechanism is provided in contact with the support body fitting 28. On another side (B) of second support body 30B, two support body fittings 28 are provided at positions offset in the X direction from each other, and rotary circular eccentric cam mechanism 110 as the first Y direction moving mechanism and rotary circular eccentric cam mechanism 120 as the second Y direction moving mechanism are provided to be in contact with the support body fittings 28, respectively. Further, on two sides (C, D) opposing to the aforementioned two sides (A, B) of second support body 30B, springs 9 are provided, one on the side C and two on the side D, so that second support body 30B is pressed against X direction moving apparatus 100, first Y direction moving apparatus 110 and second Y direction moving apparatus 120.

The rotary circular eccentric cam mechanism includes a rolling bearing 11b, a circular eccentric cam 11a to which outer periphery the rolling bearing 11b is fitted, a rotary shaft 10 transmitting rotary driving force to the circular eccentric cam 11a, and a motor for rotary-driving the rotary shaft 10. A disk shaped or cylindrical cam should preferably be used as the circular eccentric cam 11a. Further, a reading apparatus such as an encoder for reading the angle of rotation should preferably be provided on the circular eccentric cam 11a. More preferably, a motor of which angle of rotation of the output shaft is controllable should preferably be used as motor 32. Further, it is possible to perform control in which angle of rotation of the rotary shaft 10 is recognized, using a pulse motor and an apparatus for detecting an origin (0 point) of the angle of rotation θ which is the position where the circular eccentric cam 11a becomes parallel to one side of the second support body 30B which is in contact therewith. Further, a CCD camera 12 is provided on the side of substrate 2, of substrate base plate 30C.

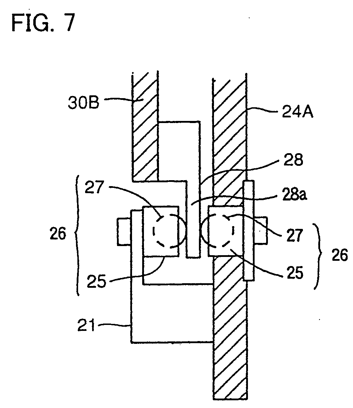

Referring to Fig. 7, detailed structure of the supporting portion of second support body 30B will be described. This is a structure supporting second support body 30B movable in the X and Y directions while preventing movement in the Z direction, in which a flat plate portion 28a of support body fitting 28 is gripped and supported by a pair of bearings 26 having balls 27 held freely rotatable by a housing 25. One of the bearings 26 is provided directly on upper base plate 24A, while the other bearing 26 is provided in a bracket 21 fixed on upper base plate 24A. Upper base plate 24A is supported by a support bar 24C on lower base plate 24B.

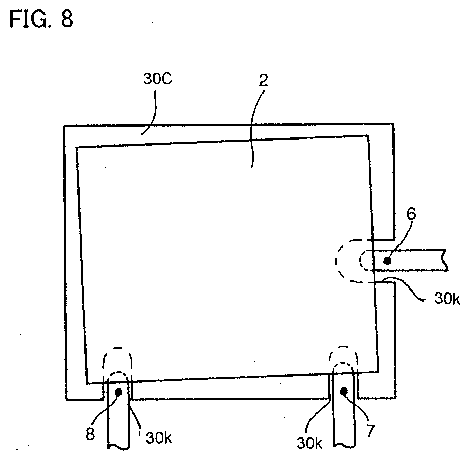

Referring to Fig. 8, substrate 2 held on substrate base plate 30C is positioned relative to upper base plate 24A in the following manner. Distance between fixing marks 6, 7 and 8 provided on upper base plate 24A and the corresponding side or positioning mark of substrate 2 is read by CCD camera 12 as the position detection sensor, and based on read information of the offset of substrate 2, the amount of offset of substrate 2 is calculated by a processor. Thereafter, based on the result of calculation, necessary angle of rotation for each circular eccentric cam 11a is provided from the processor, for X direction moving mechanism 100 and the first and second Y direction moving mechanisms 110 and 120, so as to eliminate the positional deviation of substrate 2. Substrate base plate 30C has a notch portion 30k, so that fixing marks 6, 7 and 8 provided on upper base plate 24A can be read by CCD camera 12.

### (Function and Effects)

According to the substrate positioning apparatus in accordance with the present embodiment, the X direction moving mechanism 100 and the first and second Y direction moving mechanisms 110 and 120 can be implemented by using rotary cam mechanisms, and hence the moving mechanism can be simplified. Further, by accurately controlling the angle of rotation of the rotary cam, the amount of movement of the holding apparatus can be managed accurately. Therefore, accuracy of the moving distance and reliability can be improved. It is possible to adopt such a structure that includes a belt conveyer or a roller conveyer in place of substrate base plate 30C.

### (Second Embodiment)

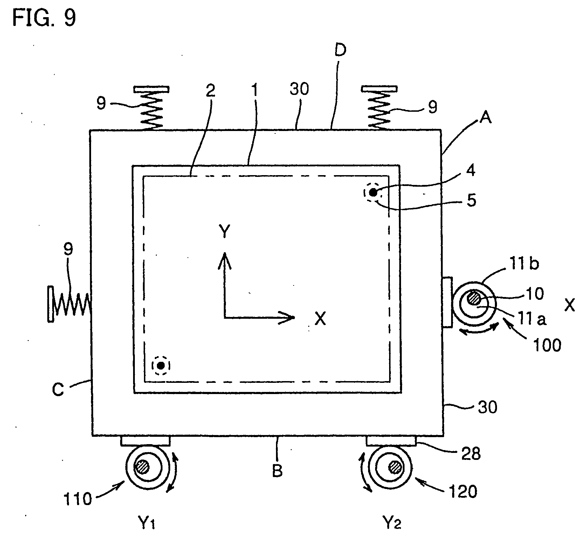

In the following, the structure of the exposure apparatus in accordance with an embodiment of the present invention will be described with reference to Fig. 9. Fig. 9 shows a principal of the method of positioning using rotary circular eccentric cam of the exposure apparatus in accordance with the present embodiment. Portions similar to or corresponding to those of the conventional exposure apparatus described with reference to Fig. 14 will be denoted by the same reference characters, and detailed description will not be repeated.

### (Schematic Structure of the Exposure Apparatus)

Referring to Fig. 9, the moving apparatus of the exposure apparatus in accordance with the present embodiment is characterized in that rotary circular eccentric cam mechanisms 100, 110 and 120 are provided, partially improving the conventional moving apparatus shown in Fig. 14.

More specifically, as the X direction moving mechanism, the rotary circular eccentric cam mechanism 100 is provided to be in contact with one side (A) of support body 30 on which photomask 1 is held, and as the first Y direction moving mechanism and the second Y direction moving mechanism, rotary circular eccentric cam mechanisms 110 and 120 are provided, opposite in the X direction from each other, to be in contact with another side (B) of support body 30. The substrate 2 positioned close to photomask 1 is represented by a two-dotted line in Fig. 9.

By such a structure, it becomes possible to move the photomask in the X, Y and θ directions relative to the substrate. Here, θ direction represents a direction of rotation in the same plane as the X and Y directions.

The rotary circular eccentric cam mechanism includes a rolling bearing 11b in contact with a support body fitting 28 provided on the side of support body 30, a circular eccentric cam 11a having the rolling bearing 11b fitted in an outer peripheral surface thereof, and a rotary shaft 10 transmitting the rotary driving force to the circular eccentric cam 11a. Though rolling bearing 11b is provided to reduce rolling friction, support body fitting 28 may be provided slidable along the side of support body 3, instead of providing the rolling bearing 11b.

The relation between the angle of rotation θ and the amount of movement S is the same as described with reference to Fig. 2. Therefore, description thereof will not be repeated here.

### (Processor)

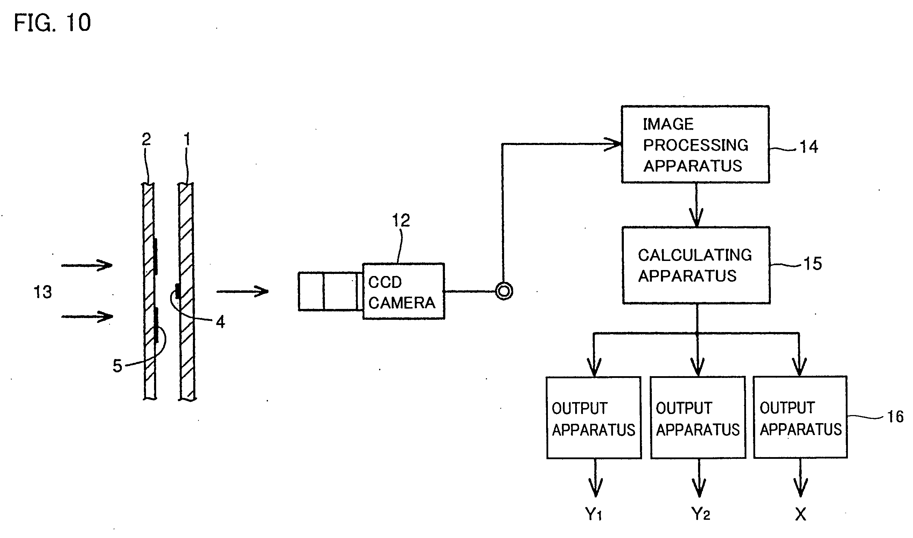

Fig. 10 is a block diagram of the processor reading the alignment mark 4 provided on photomask 1 and alignment mark 5 provided on substrate 2 by a CCD camera 12 and performing data processing thereof. More specifically, alignment mark 4 of photomask 1 and alignment mark 5 of substrate 2 are irradiated by a light source 13 with the photomask 1 and substrate 2 overlapped with each other, and read by CCD camera 12.

The image of the read alignment marks 4 and 5 is processed by image processing apparatus 14, of which data is transmitted to a calculating apparatus 15, where the amount of positional deviation between alignment mark 4 and alignment mark 5 is calculated and the amount of movement of each of the rotary circular eccentric cam mechanisms 100, 110 and 120 for canceling the amount of positional deviation is calculated, and transmitted to an output apparatus 16 for driving the rotary circular eccentric cam mechanisms 100, 110 and 120. The mechanism of the calculating apparatus is applicable to the substrate positioning apparatus in accordance with the first embodiment described above.

### (More Specific Structure of the Exposure Apparatus)

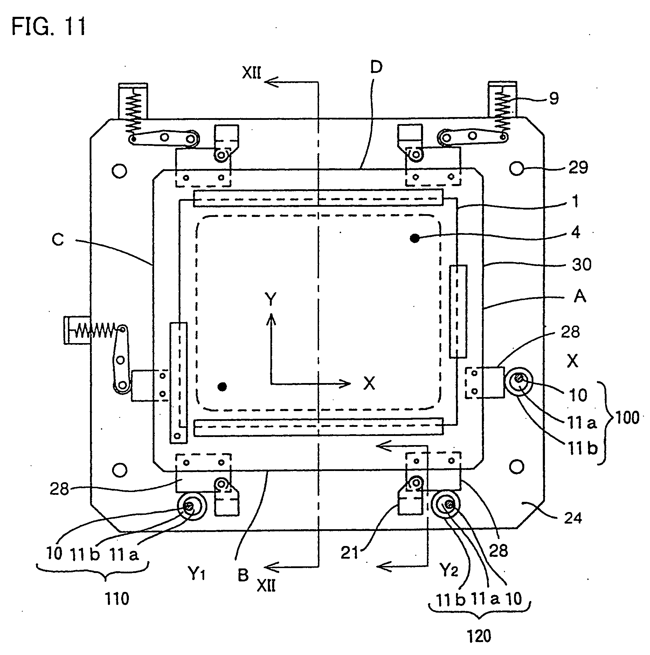

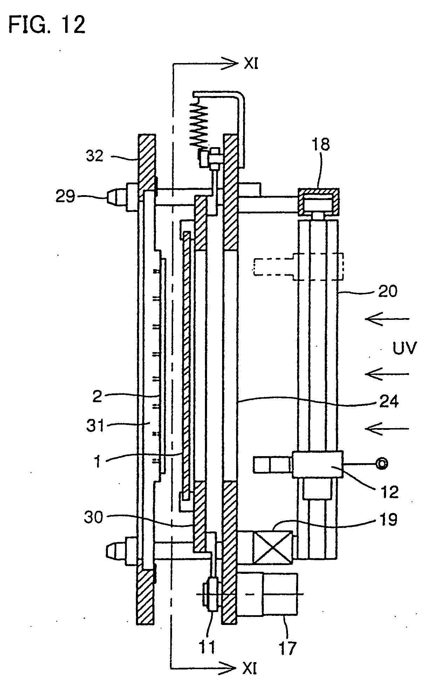

More specific structure of the exposure apparatus using the rotary circular eccentric cam mechanisms in accordance with the present embodiment will be described with reference to Figs. 11 and 12. Fig. 11 is a plan view (viewed from the line XI-XI of Fig. 12) showing the structure of the exposure apparatus in accordance with the present embodiment, and Fig. 12 is a cross sectional view taken along the line XII-XII of Fig. 11.

Similar to the exposure apparatus shown in Fig. 9, photomask 1 is held by a support body 30. Substrate 2 is supported by a substrate holder 31 by vacuum suction, and the substrate holder 31 is supported by a substrate base plate 32. Substrate base plate 32 is supported on a base plate 24 by means of a guide pin 29.

On one side (A) of support body 30, support body fitting 28 is provided, and as the X direction moving mechanism, the rotary circular eccentric cam mechanism 100 is provided to be in contact with the support body fitting 28. On another side (B) of support body 30, two support body fittings 28 are provided offset from each other in the X direction, and as the first and second Y direction moving mechanisms, rotary circular eccentric cam mechanisms 110 and 120 are provided to be in contact with the support body fittings 28, respectively. On two sides (C, D) opposing to the two sides (A, B) of support body 30, springs 9 are provided, one on side C and two on side D, to press the support body 30 in the direction of X direction moving apparatus 100 and the first and second Y direction moving apparatuses 110 and 120.

The rotary circular eccentric cam mechanism includes a rolling bearing 11b, a circular eccentric cam 11a having the rolling bearing 11b fitted on an outer peripheral surface thereof, a rotary shaft 10 transmitting a rotary driving force to the circular eccentric cam 11a, and a motor 17 for driving and rotating the rotary shaft 10. A disk shaped or a cylindrical, circular eccentric cam 11a is preferred. Preferably, a reading apparatus such as an encoder for reading the angle of rotation of circular eccentric cam 11a is provided on the rotary shaft 10. More preferably, a motor of which angle of rotation of an output axis is controllable, should be used as motor 17. Alternatively, the origin (0 point) of the angle of rotation θ, which is the position where the aforementioned line and the side of support body 30 with which the circular eccentric cam 11 is in contact are parallel to each other may be detected by a detecting apparatus, and a pulse motor or a servo motor that can accurately control the angle of rotation from the origin to the necessary angle may be used to rotate the rotary shaft 10.

On the light source side of base plate 24, an apparatus 20 for moving a camera in X direction is provided, supporting CCD camera 12 movable in the X direction, and an apparatus 19 for moving the camera in Y direction is further provided, supporting the apparatus 20 movable in the Y direction. Fig. 5 shows a guide rail 18 supporting CCD camera 12 movable in the Y direction.

The detailed structure of the supporting portion of support body 3 is the same as the structure shown in Fig. 5. Therefore, description thereof will not be repeated.

### (Function and-Effects)

As described above, by the exposure apparatus in accordance with the present embodiment, the X direction moving mechanism 100, the first Y direction moving mechanism 110 and the second Y direction moving mechanism 120 can be realized by rotating cam mechanisms, and hence moving mechanisms can be simplified. Further, by accurately controlling the rotating angle of the rotating cam, the amount of movement of the holding apparatus can be adjusted accurately. Therefore, accuracy in the distance of movement and the reliability can be improved. In the processor shown in Fig. 10, a program for calculating the angle of rotation θ of the rotary eccentric cam 11a is necessary. However, as the structure of the moving mechanisms can be simplified, the cost of the overall exposure apparatus can be reduced.

Further, in the above described embodiment, the support body 30 supporting photomask 1 is made movable in X and Y directions while substrate holder 31 supporting the substrate 2 is fixed. It is also possible to fix the support body 30 supporting photomask 1, while substrate holder 31 supporting the substrate 2 is made movable in X and Y direction. Any mechanism may be adapted, provided that photomask 1 and substrate 2 can be moved in X, Y and θ directions relative to each other.

In the substrate positioning apparatus and the exposure apparatus of the present invention, as the X direction moving mechanism and the first and second Y direction moving mechanisms are implemented by rotating cam mechanisms, the moving mechanisms can be simplified and the cost necessary for each moving apparatus can be reduced. Further, by accurately controlling the rotating angle of the rotating cam, the amount of movement of the holding apparatus can be adjusted accurately, and hence accuracy in positioning and the reliability can be improved.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A substrate positioning apparatus, having a base plate (24A), holding means (30, 30B, 30C) provided on the base plate (24A) and holding a substrate (2) movable in X, Y and θ directions including a plane of the substrate (2), detecting positions of a plurality of sides of said substrate (2) or a position of a positioning mark by a position detection sensor, calculating an amount of deviation from a predetermined position of the substrate (2), and positioning said substrate (2) by moving said holding means (30, 30B, 30C) in the X, Y and θ directions based on the result of calculation to eliminate the amount of deviation, comprising:
an X direction moving mechanism (100) moving said holding means (30, 30B, 30C) in the X direction;
a first Y direction moving mechanism (110) moving said holding means (30, 30B, 30C) in the Y direction; and
a second Y direction moving mechanism (120) positioned offset in the X direction from said first Y direction moving mechanism (110), moving said holding means (30, 30B, 30C) in the Y direction; wherein
said X direction moving mechanism (100), said first Y direction moving mechanism (110) and said second Y direction moving mechanism (120) are implemented by rotary cam mechanisms (10, 11a) in contact with said holding means (30, 30B, 30C).

2. The substrate positioning apparatus according to claim 1, wherein
an eccentric rotary member (11a) implemented as a disk or a cylindrical circular eccentric cam attached eccentrically on a rotary shaft (10), and
a rolling bearing (11b) fitted in an outer periphery of said eccentric rotary member (11a); and
an outer periphery of said rolling bearing (11b) is in contact with said holding means (30, 30B, 30C).

3. The substrate positioning apparatus according to claim 1, wherein
said rotary shaft (10) further includes reading means for reading angle of rotation of said eccentric rotary member (11a).

4. The substrate positioning apparatus according to claim 2, wherein necessary angle of rotation each said circular eccentric cam to eliminate positional deviation of said substrate (2) is calculated by a processor based on the amount of deviation of said substrate (2) read by said position detection sensor, and each said circular eccentric cam is rotated in accordance with the data.

5. The substrate positioning apparatus according to claim 1, wherein
a fixing mark (6, 7, 8) positioned outer than a side of said substrate (2) is provided on said base plate (24A), a distance between the plurality of sides of said substrate (2) or the positioning mark and said fixing mark (6, 7, 8) is read by said position detection sensor, and based on the read data, said substrate (2) is positioned so that the distance between the plurality of sides of said substrate (2) or the positioning mark and said fixing mark (6, 7, 8) attains to a predetermined value.

6. The substrate positioning apparatus according to claim 2, wherein
each said eccentric rotary member (11a) includes said disk shaped or said cylindrical circular eccentric cam directly attached to an output shaft of a motor of which angle of rotation is controllable.

7. An exposure apparatus, in which a photomask (1) and a substrate (2) are overlapped close to each other or in contact with each other, a pattern drawn on said photomask (1) being transformed to said substrate (2) by irradiating said substrate (2) with light through said photomask (1), wherein
said photomask (1) and said substrate (2) are provided with a plurality of alignment marks (4, 5) at positions corresponding to each other, for alignment of said photomask (1) and said substrate (2);
the alignment marks (4, 5) of said photomask (1) and said substrate (2) are read by a CCD camera (12) with said photomask (1) and said substrate (2) overlapped with each other;
said exposure apparatus comprising
alignment means (100, 110, 120) for aligning said photomask (1) and said substrate (2), as said photomask (1) and said substrate (2) are moved in X, Y and θ directions relative to each other, based on data read by said CCD camera (12),
said alignment means (100, 110, 120) having
holding means (30, 30B, 30C) for holding one of said photomask (1) or said substrate (2) that moves, and movable along a plane direction of said photomask (1) or said substrate (2),
an X direction moving mechanism (100) for moving said holding means (30, 30B, 30C) in the X direction,
a first Y direction moving mechanism (110) for moving said holding means (30, 30B, 30C) in the Y direction, and
a second Y direction moving mechanism (120) positioned offset in X direction from said first Y direction moving mechanism (110) and moving said holding means (30, 30B, 30C) in the Y direction,
said X direction moving mechanism (100), said first Y direction moving mechanism (110) and said second Y direction moving mechanism (120) are each a rotating cam mechanism (10, 11a) in contact with said holding means (30, 30B, 30C).

8. The exposure apparatus according to claim 7, wherein
said rotating cam mechanism includes
an eccentric rotary member (11a) consisting of a disk or a cylindrical circular eccentric cam attached eccentrically on a rotary shaft (10), and
a rolling bearing (11b) fitted in an outer periphery of said eccentric rotary member (11a),
said rolling bearing (11b) having an outer periphery being in contact with said holding means (4).

9. The exposure apparatus according to claim 7, wherein
said rotary shaft (10) further includes reading means for reading an angle of rotation of said eccentric rotary member (11a).

10. The exposure apparatus according to claim 8, further comprising:
image processing means (14) for recognizing an amount of positional deviation between said photomask (1) and said substrate (2) read by said CCD camera (12); and
output means (15, 16) for calculating the amount of positional deviation between said photomask (1) and said substrate (2) based on information from said image processing means (14), and for outputting necessary angle of rotation of each said eccentric rotary member (11a) to said X direction moving mechanism (100), said first Y direction (moving mechanism (110) and said second Y direction moving mechanism (120), so as to eliminate the positional deviation between said photomask and said substrate.

11. The exposure apparatus according to claim 8, wherein each said eccentric rotary member (11a) includes said disk shaped or said cylindrical circular eccentric cam (11a) attached directly on an output shaft of a motor, of which angle of rotation is controllable.
